(19) Europäisches Patentamt
European Patent Office
Office européen des brevets

(11) **EP 1 399 994 B1**

(12) **EUROPÄISCHE PATENTSCHRIFT**

(45) Veröffentlichungstag und Bekanntmachung des Hinweises auf die Patenterteilung:
**27.07.2005 Patentblatt 2005/30**

(21) Anmeldenummer: 02747173.9

(22) Anmeldetag: **23.05.2002**

(51) Int Cl.[7]: **H01S 5/34**, H01S 5/183

(86) Internationale Anmeldenummer:
**PCT/DE2002/001895**

(87) Internationale Veröffentlichungsnummer:
**WO 2003/001636 (03.01.2003 Gazette 2003/01)**

(54) **PHOTONEN-EMITTER UND DATENÜBERTRAGUNGSVORRICHTUNG**

PHOTON EMITTER AND DATA TRANSMISSION DEVICE

EMETTEUR DE PHOTONS ET DISPOSITIF DE TRANSMISSION DE DONNEES

(84) Benannte Vertragsstaaten:
**DE FR GB IT**

(30) Priorität: **20.06.2001 DE 10129587**
**17.07.2001 DE 10134825**

(43) Veröffentlichungstag der Anmeldung:
**24.03.2004 Patentblatt 2004/13**

(73) Patentinhaber: **Infineon Technologies AG**
**81669 München (DE)**

(72) Erfinder: **MICHLER, Peter**
**28215 Bremen (DE)**

(74) Vertreter: **Viering, Jentschura & Partner**
**Steinsdorfstrasse 6**
**80538 München (DE)**

(56) Entgegenhaltungen:
**EP-A- 0 892 474      US-A- 5 289 018**
**US-A- 5 953 356**

- **RIBBAT CH ET AL: "High power quantum dot lasers at 1140 nm" CONFERENCE DIGEST. 2000 IEEE 17TH INTERNATIONAL SEMICONDUCTOR LASER CONFERENCE. (CAT. NO.00CH37092), CONFERENCE DIGEST. 2000 IEEE 17TH INTERNATIONAL SEMICONDUCTOR LASER CONFERENCE, MONTEREY, CA, USA, 25-28 SEPT. 2000, Seiten 131-132, XP001094183 2000, Piscataway, NJ, USA, IEEE, USA ISBN: 0-7803-6259-4**
- **LITVINOV D ET AL: "Growth and vertical correlation of CdSe/ZnSe quantum dots" JOURNAL OF APPLIED PHYSICS, 1 APRIL 2001, AIP, USA, Bd. 89, Nr. 7, Seiten 3695-3699, XP001094182 ISSN: 0021-8979**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft einen Photonen-Emitter eine Datenübertragungsvorrichtung.

Ein solcher Photonen-Emitter ist aus [1] bekannt.

Bei diesem aus [1] bekannten Bauelement wurde beschrieben, dass bei einer Betriebstemperatur von 50 mK einzelne Photonen mit einer Frequenz von 10 MHz emittiert werden können. Der Photonen-Emitter gemäß [1] ist ein Bauelement, welches einen mesoskopischen Doppelbarrieren-pn-Heteroübergang mit einem Quantenfilm als aktiver Schicht zum Emittieren der Photonen aufweist. Dieser Photonen-Emitter basiert auf dem Prinzip der Coulomb-Blokkade für Elektronen und Löcher. Die Coulomb-Blockade verhindert, dass mehr als ein Elektron in den aktiven Quantenfilm tunneln kann. Bei dem Photonen-Emitter gemäß [1] muss die Ladungsenergie eines einzelnen Elektrons größer sein als die thermische Hintergrundenergie. Aus diesem Grund ist die Anwendbarkeit dieses bekannten Bauelements auf sehr tiefe Temperaturen im Bereich von mK beschränkt.

Weiterhin ist es aus [2] bekannt, dass ein in einem Halbleiter sich befindender Quantenpunkt in einem Resonator zur Erzeugung einzelner Photonen genutzt werden könnte.

In [3] ist experimentell nachgewiesen, dass dies auch bei nicht resonantem, optischem Pumpen des Quantenpunkts, anders ausgedrückt durch ein Anregen des Quantenpunkts durch optisches Pumpen, möglich ist.

In diesem Zusammenhang ist darauf hinzuweisen, dass der exzitonische Grundzustand eines Quantenpunkts, welcher durch selbstorganisiertes Wachstum hergestellt wird, nur innerhalb der inhomogenen Linienbreite des Quantenpunktarrays vorhergesagt werden kann. Aus diesem Grund stimmen die exzitonischen Grundzustandsenergie eines Quantenpunkts und die Energie der Resonatormode eines Resonators nur zufällig und somit nicht deterministisch vorhersagbar überein.

Aus diesem Grund sind die Photonen-Emitter aus [2] oder [3] nicht für die Massenanwendung geeignet.

In [5] und [6] ist jeweils ein vertikaler Langwellen-Laserresonator mit einem integrierten Kurzwellen-Pumplaser beschrieben. Die angeregte Emission von dem Kurzwellen-Laser bewirkt, dass sie den Langwellen-Laser aktiviert. Ein optisch transparenter Klebstoff befestigt die Laser in vertikaler Ausrichtung.

Ferner ist ein lichtemittierendes Halbleiterelement mit einem Quantenpunkt-Bereich in [7] oder in [8] offenbart.

Somit liegt der Erfindung das Problem zugrunde, einen Photonen-Emitter sowie eine Datenübertragungsvorrichtung mit einem Photonen-Emitter anzugeben, welcher für den Einsatz auch bei höheren Temperaturen geeignet ist.

EP-A-0 892 474 offenbart einen Photonen-Emitter, der aus zwei übereinander, monolithisch integrierten vertikalen Laserresonatoren besteht. Der obere, zweite Resonator enthält eine aktive Schicht 10 mit Quantenpunkten. Der untere, erste Resonator pumpt den zweiten Resonator. Durch Anlegen eines elektrischen Feldes kann im zweiten Resonator der exzitonische Grundzustand in Resonanz mit einer Resonatormode gebracht werden.

Das Problem wird durch den Photonen-Emitter mit den Merkmalen gemäß dem unabhängigen Patentanspruch gelöst.

Ein Photonen-Emitter weist einen strahlungsemittierenden ersten Resonator auf sowie einen zweiten Resonator, der mindestens einen Quantenpunkt enthält. Der zweite Resonator ist in Emissionsrichtung der von dem ersten Resonator emittierten Strahlung angeordnet derart, dass der Quantenpunkt in dem zweiten Resonator von der emittierten Strahlung energetisch angeregt werden kann. Ferner weist der Photonen-Emitter eine Steuerungseinheit auf, die mit dem zweiten Resonator gekoppelt ist und die derart eingerichtet ist, dass der exzitonische Grundzustand des Quantenpunkts in dem zweiten Resonator derart eingestellt werden kann, dass er in Resonanz mit einer vorgegebenen Resonatormode des zweiten Resonators gebracht werden kann.

Die Einstellung erfolgt vorzugsweise unter Verwendung eines elektrischen Feldes, welches mittels der Steuerungseinheit an den zweiten Resonator und somit an den Quantenpunkt bzw. eine Mehrzahl von Quantenpunkten in dem zweiten Resonator angelegt wird.

Anschaulich basiert das Verschieben des exzitonischen Grundzustands auf dem sogenannten "**Q**uantum **C**onfined **S**tark **E**ffect" (QCSE), der anschaulich darin besteht, dass die Grundenergie eines Quantenpunkts mittels Anlegen eines elektrischen Feldes veränderbar ist.

Anschaulich kann die Erfindung in einem Einzel-Photonen-Emitter gesehen werden, der zwei Resonatoren aufweist, wobei ein Resonator als optische Pumpe für den zweiten Resonator ausgestaltet ist. In dem zweiten Resonator vorhandene Quantenpunkte können mittels des optischen Pumpens der von dem ersten Resonator emittierten Strahlung angeregt werden, so dass einzelne Photonen von dem zweiten Resonator emittiert werden.

Wird genau ein Quantenpunkt der in dem zweiten Resonator vorhandenen Vielzahl von Quantenpunkten in Resonanz mit dem zweiten Resonator gebracht, d.h. wenn der exzitonische Grundzustand genau eines Quantenpunkts in dem zweiten Resonator derart eingestellt wird, dass er in Resonanz mit dem zweiten Resonator ist, wird pro elektrischem Anregungspuls genau ein Photon von dem Photonen-Emitter emittiert, d.h. der Photonen-Emitter stellt in diesem Fall einen insbesondere in der sicheren Datenübertragung sehr vorteilhaft einsetzbaren Einzel-Photonen-Emitter dar.

Bevorzugte Weiterbildungen der Erfindung ergeben sich aus den abhängigen Ansprüchen.

Der erste Resonator ist gemäß einer Ausgestaltung der Erfindung ein vertikal emittierendes Laserelement.

Ist der erste Resonator ein vertikal emittierendes Laserelement, so ergibt sich für den Photonen-Emitter ein äußerst kompakter und mit Standardprozessen sehr kostengünstig herstellbares Bauelement als Photonen-Emitter.

Die Steuerungseinheit ist gemäß einer Ausgestaltung der Erfindung derart eingerichtet, dass der exzitonische Grundzustand des aktiven Quantenpunkts in dem zweiten Resonator mittels Anlegen eines elektrischen Feldes einstellbar ist.

Der erste Resonator und/oder der zweite Resonator können als DBR-Resonatoren (**D**istributed **B**ragg **R**esonator) ausgestaltet sein.

Durch diese Weiterbildung der Erfindung ist ein sehr einfacher und kompakter Photonen-Emitter angegeben.

Gemäß einer weiteren Ausgestaltung der Erfindung ist/sind der erste Resonator und/oder der zweite Resonator als Resonator aus Aluminium-Gallium-Arsenid hergestellt.

Der erste Resonator kann folgenden Aufbau haben:

- Eine erste Reflektorschicht,
- eine auf der ersten Reflektorschicht aufgebrachte erste Begrenzungsschicht,
- eine auf der ersten Begrenzungsschicht aufgebrachte aktive Schicht,
- eine auf der aktiven Schicht aufgebrachte zweite Begrenzungsschicht, und
- eine auf der zweiten Begrenzungsschicht aufgebrachte zweite Reflektorschicht.

Die erste Reflektorschicht, die erste Begrenzungsschicht, die zweite Begrenzungsschicht und die zweite Reflektorschicht können aus Aluminium-Gallium-Arsenid hergestellt sein.

Die aktive Schicht kann Gallium-Arsenid enthalten

Alternativ können für die aktive Schicht ternäre Halbleiterverbindungen aus Zink-Cadmium-Selenid, Indium-Gallium-Nitrid, Indim-Gallium-Phosphid Verwendung finden.

Bei Verwendung von Zink-Cadmium-Selenid als aktiver Schicht kann Zink-Selenid oder eine quaternäre Halbleiterverbindung aus Magnesium-Zink-Schwefel-Selen, bei Indium-Gallium-Nitrid als aktiver Schicht kann Aluminum-Gallium-Nitrid, bei Indim-Gallium-Phosphid als aktiver Schicht kann ein quaternäre Halbleiterverbindung aus Aluminium-Gallium-Indium-Phosphor jeweils als Reflektorschicht verwendet werden.

Allgemein kann jede beliebige und geeignete Halbleiterstruktur verwendet werden, die einen entsprechenden für einen Photonen-Emitter geeignete Energiebandverlauf aufweist.

Es kann insbesondere jedes beliebige Halbleiterelement, vorzugsweise jede geeignete III-V-Halbleiter-Heterostruktur oder II-VI-Halbleiter-Heterostruktur verwendet werden.

Der zweite Resonator kann folgende Struktur aufweisen:

- Eine dritte Reflektorschicht,
- eine auf der dritten Reflektorschicht aufgebrachte dritte Begrenzungsschicht,
- eine auf der dritten Begrenzungsschicht aufgebrachte Quantenpunkt-Schicht mit mindestens einem Quantenpunkt, vorzugsweise mit mehreren Quantenpunkten,
- eine auf der Quantenpunkt-Schicht aufgebrachte vierte Begrenzungsschicht, und
- eine auf der vierten Begrenzungsschicht aufgebrachte vierte Reflektorschicht.

Die dritte Reflektorschicht, die dritte Begrenzungsschicht, die vierte Begrenzungsschicht und die vierte Reflektorschicht können Aluminium-Gallium-Arsenid enthalten, alternativ die gleichen Materialien wie die erste Reflektorschicht, die erste Begrenzungsschicht, die zweite Begrenzungsschicht und die zweite Reflektorschicht des ersten Resonators.

Die Quantenpunkt-Schicht kann gemäß dieser Ausgestaltung der Erfindung Indium-Arsenid oder Indium-Gallium-Arsenid enthalten.

Alternativ kann die Quantenpunkt-Schicht Cadmium-Selenid oder Zink-Cadmium-Selenid für den Fall aufweisen, dass die Reflektorschichten und die Begrenzungsschichten des zweiten Resonators Zink-Selenid und/oder Zink-Sulfid-Selenid und/oder Zink-Magnesium-Sulfid-Selenid enthalten.

Sind die Reflektorschichten und die Begrenzungsschichten des zweiten Resonators aus Aluminium-Gallium-Indium-Phosphid gefertigt, so weist die Quantenpunkt-Schicht vorzugsweise Indium-Phosphid oder Indium-Gallium-Phospid auf.

Sind die Reflektorschichten und die Begrenzungsschichten des zweiten Resonators aus Aluminium-Nitrid gefertigt, so weist die Quantenpunkt-Schicht vorzugsweise Gallium-Nitrid oder Indium-Gallium-Nitrid auf.

Zwischen der dritten Reflektorschicht und der Quantenpunkt-Schicht und/oder zwischen der Quantenpunkt-Schicht und der vierten Reflektorschicht ist gemäß einer weiteren Ausgestaltung der Erfindung eine Tunnelbarrieren-Schicht vorgesehen, um ein Tunneln der Ladungsträger aus den Quantenpunkten in die Begrenzungsschichten zu verhindern.

Durch diese Ausgestaltung der Erfindung wird der Wirkungsgrad des Photonen-Emitters weiter erhöht.

Gemäß einer weiteren Ausgestaltung der Erfindung ist an zumindest einer Seitenwand des zweiten Resonators, vorzugsweise um den gesamten Umfang des zweiten Resonators mindestens ein optischer Seitenspiegel angebracht. Vorzugsweise ist der gesamte Umfang des zweiten Resonators mit optischen Seitenspiegeln versehen, um den Wirkungsgrad des Photonen-Emitters weiter zu erhöhen.

Der Photonen-Emitter kann sehr vorteilhaft eingesetzt werden im Bereich der Datenkommunikation, insbesondere im Bereich der abhörsicheren Datenkommunikation, die im Bereich der weltweiten digitalen Kommunikationsnetze sehr große Bedeutung gewinnt, insbesondere im Bereich des Internets.

Ausführungsbeispiele der Erfindung sind in den Figuren dargestellt und werden im Weiteren näher erläutert.

Es zeigen

Figur 1     eine Querschnittsansicht eines Photonen-Emitter gemäß einem ersten Ausführungsbeispiel der Erfindung;

Figur 2     eine Querschnittsansicht eines Photonen-Emitters gemäß einem zweiten Ausführungsbeispiel der Erfindung;

Figur 3     ein Diagramm, in dem die Abstimmung der des exzitonischen Grundzustands eines Quantenpunkts in dem zweiten Resonator mit der vorgegebenen Resonatormode dargestellt ist. Des weiteren ist die Resonatormode des ersten Resonators bzgl. der energetischen Lage zum zweiten Resonator dargestellt.

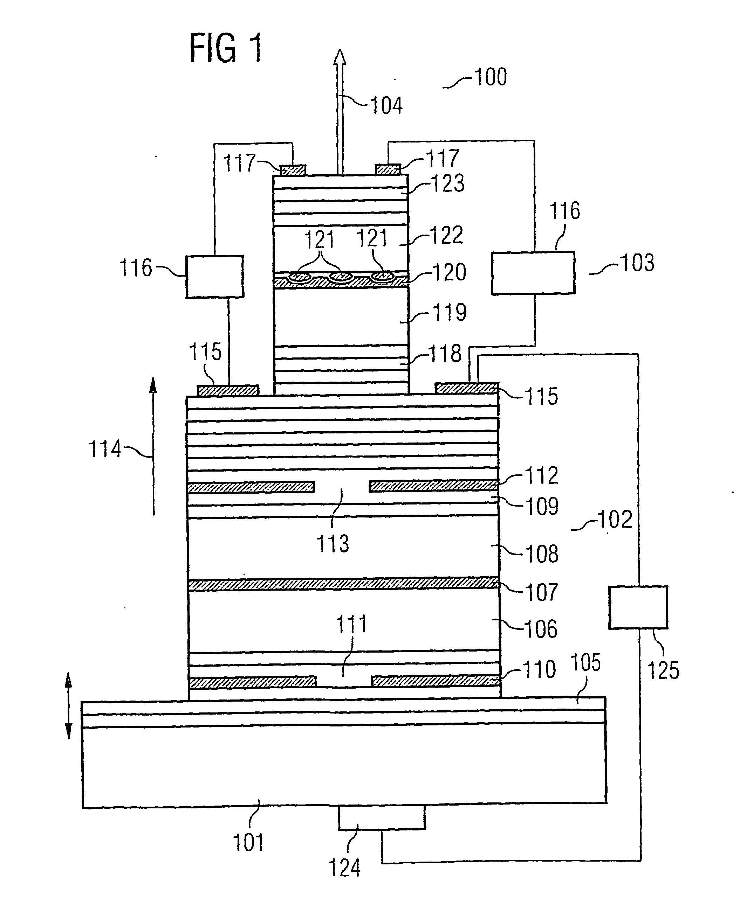

**Fig. 1** zeigt eine Querschnittsansicht eines Photonen-Emitters 100 gemäß einem ersten Ausführungsbeispiel der Erfindung.

Auf einem Substrat 101 aus Gallium-Arsenid mit einer Dicke von bis zu einem halben Millimeter, grundsätzlich einer beliebigen Dicke, ist ein erster Resonator 102 aufgebracht, dessen Struktur im Weiteren noch näher erläutert wird.

Auf dem ersten Resonator, der als vertikal emittierendes Laserelement ausgestaltet ist, ist ein zweiter Resonator 103, der ebenfalls im Weiteren näher erläutert wird, aufgebracht, derart, dass in einer durch einen Pfeil 104 symbolisierten Emissionsrichtung einzelne Photonen emittiert werden können.

Der erste Resonator 102 weist als vertikal emittierendes Laserelement eine ersten Reflektorschicht, ausgestaltet als Bragg-Reflektor der Dicke zwischen einem bis zwei μm auf, abhängig von der Wellenlänge des von dem Laserelement zu emittierenden Lichtstrahls, allgemein mit einer Schichtdicke einer Einzelschicht des Braggreflektors von einem Viertel der Wellenlänge des zu emittierenden Lichtstrahls.

Die erste Reflektorschicht 105, ausgestaltet als DBR-Reflektorschicht, ist aus folgender Materialkombination gefertigt:

$$Al_{0.1}Ga_{0.9}As \, / \, Al_{0.4}Ga_{0.6}As.$$

Auf der ersten Reflektorschicht 105 ist eine erste Begrenzungsschicht 106 aus $Al_{0.1}Ga_{0.9}As$ der Dicke von ca. 100 nm aufgebracht. Allgemein entspricht die Summe der Dicken der Begrenzungsschichten und der aktiven Schicht einer Wellenlänge oder ein Vielfaches der Wellenlänge des emittierten Lichts.

Auf der ersten Begrenzungsschicht 106 ist eine aktive Schicht 107 der Dicke von 10 bis 20 nm, allgemein abhängig wiederum von der Wellenlänge λ des von dem ersten Resonator 102 emittierten Lichtstrahls aufgewachsen derart, dass gilt:

$$h \times \nu < E_g \, (Al_{0.1}Ga_{0.9}As).$$

wobei mit

- h die Plancksche Konstante,
- $\nu$ die Frequenz des von dem ersten Resonator 102 emittierten Lichtstrahls, und
- $E_g$ der Bandabstand zwischen dem Valenzband und dem Leitungsband des Materials der aktiven Schicht 107, bezeichnet wird.

Auf der aktiven Schicht 107 ist eine zweite Begrenzungsschicht 108 ebenfalls der Dicke 100 nm aufgewachsen, wobei die zweite Begrenzungsschicht 108 aus dem gleichen Material gefertigt ist wie die zweite Begrenzungsschicht 106, das heißt gemäß diesem ersten Ausführungsbeispiel aus $Al_{0.1}Ga_{0.9}As$.

Auf der zweiten Begrenzungsschicht 108 ist wiederum eine Reflektorschicht, die zweite Reflektorschicht 109, ebenfalls ausgestaltet als DBR-Reflektorschicht, aufgewachsen der Dicke 1 bis 2 µm, welche aus dem gleichen Material gefertigt ist wie die erste Reflektorschicht 105, das heißt gemäß diesem Ausführungsbeispiel aus $Al_{0.1}Ga_{0.9}As$ / $Al_{0.4}Ga_{0.6}As$.

Ferner ist in der ersten Reflektorschicht 105 eine erste Blende 110 eingebracht mit einer Öffnung 111 der Breite zwischen einem bis drei µm. In der zweiten Reflektorschicht 109 ist eine zweite Blende 112 eingebracht, ebenfalls mit einer Öffnung der Breite 113 zwischen einem und drei µm.

Die Blenden 110, 112 dienen zur Stromeinschnürung. Die Emissionsrichtung des von dem ersten Resonator 102 emittierten Lichtstrahls ist in **Fig.1** durch einen weiteren Pfeil 114 symbolisiert.

Der erste Resonator 102 wird unter Verwendung üblicher Halbleiterprozessschritte gefertigt.

Auf der zweiten Reflektorschicht 109 ist ein erster elektrischer Kontakt 115 aufgebracht, an den eine Steuerungseinheit 116 angeschlossen ist zum Anlegen eines elektrischen Feldes zwischen dem ersten elektrischen Kontakt 115 und einem im weiteren beschriebenen zweiten elektrischen Kontakt 117.

Auf dem ersten Resonator 102 ist ein zweiter Resonator 103 aufgewachsen, dessen Aufbau im Weiteren näher erläutert wird.

Direkt auf der zweiten Reflektorschicht 109 des ersten Resonators 102 ist eine dritte Reflektorschicht 118 des zweiten Resonators 103 aufgewachsen, wobei die dritte Reflektorschicht 118 in gleicher Weise ausgestaltet ist, das heißt aus dem gleichen Material gefertigt ist, wie die erste und die zweite Reflektorschicht 105, 109 und ebenfalls ausgestaltet ist als DBR-Reflektorschicht. Dies bedeutet, dass die dritte Reflektorschicht 118 aus $Al_{0.1}Ga_{0.9}As$ / $Al_{0.4}Ga_{0.6}As$ gefertigt ist.

Die Dicke der dritten Reflektorschicht beträgt ebenfalls 1 bis 2 µm.

Auf der dritten Reflektorschicht 118 ist eine dritte Begrenzungsschicht 119 aufgewachsen aus Gallium-Arsenid (GaAs) der Dicke von ungefähr 100 nm.

Auf der dritten Begrenzungsschicht ist eine Quantenpunkt-Schicht 120 aufgewachsen mittels des sogenannten Stranski-Krastanov-Verfahrens derart, dass in der Quantenpunkt-Schicht 120 Quantenpunkte 121 gebildet werden.

Die Quantenpunkt-Schicht 120 wird gemäß diesem Ausführungsbeispiel aus InAs oder (InGa)As gefertigt, wobei die Quantenpunkt-Schicht 120 eine Dicke von ungefähr 2-7 nm aufweist.

Auf der Quantenpunkt-Schicht 120 ist eine vierte Begrenzungsschicht 122 aufgewachsen, ebenfalls aus GaAs, das heißt in entsprechender Weise wie die dritte Begrenzungsschicht 119.

Abschließend ist auf der vierten Begrenzungsschicht 122 eine vierte Reflektorschicht 123 aufgewachsen, die als DBR-Reflektorschicht ausgestaltet ist und somit ebenfalls als Bragg-Reflektor dient. Die vierte Begrenzungsschicht 122 ist ebenfalls aus $Al_{0.1}Ga_{0.9}As$ / $Al_{0.4}Ga_{0.6}As$ gefertigt.

Die Dicke der vierten Reflektorschicht 123 beträgt ebenfalls 1 bis 2 µm.

Auf der vierten Reflektorschicht 123 ist der zweite elektrische Kontakt 117 aufgebracht.

Die Emission von Photonen, die von den Quantenpunkten 121 emittiert werden, werden in Richtung des durch den Pfeil 104 symbolisierten Strahlprofils emittiert.

Erfindungsgemäß ergibt sich ein rundes Strahlprofil, welches sich sehr gut zur Einkopplung in einen Lichtwellenleiter eignet.

Der exzitonische Grundzustand eines jeweiligen Quantenpunkts 121 in der Quantenpunkt-Schicht 120 wird mittels der Steuerungseinrichtung 116 mit einer frei vorgebbaren Resonatormode des zweiten Resonators 103 in Resonanz gebracht.

Dies erfolgt anschaulich aufgrund des sogenannten "**Q**uantum **C**onfined **S**tark **E**ffects" (QCSE), das heißt durch Anlegen eines veränderbaren elektrischen Feldes zwischen den beiden elektrischen Kontakten des Photonen-Emitters 100, gemäß diesem Ausführungsbeispiel durch Anlegen einer veränderbaren elektrischen Spannung zwischen den ersten elektrischen Kontakt 115 und den zweiten elektrischen Kontakt 117.

In diesem Zusammenhang ist darauf hinzuweisen, dass gemäß diesem Ausführungsbeispiel die Reflektivität R der dritten Reflektorschicht 118 größer ist als die Reflektivität R der vierten Reflektorschicht 123.

Ferner ist zwischen den elektrischer Kontakt 115 und einem weiteren elektrischen Kontakt 124 am Substrat 101 eine weitere Steuerungseinheit 125 geschaltet, mittels der Strompulse in den ersten Resonator 102 gespeist werden. Auf diese Weise werden von dem ersten Resonator 102 Laserpulse erzeugt, welche die Quantenpunkte 121 in der Quantenpunkt-Schicht 120 des zweiten Resonators 103 anregen.

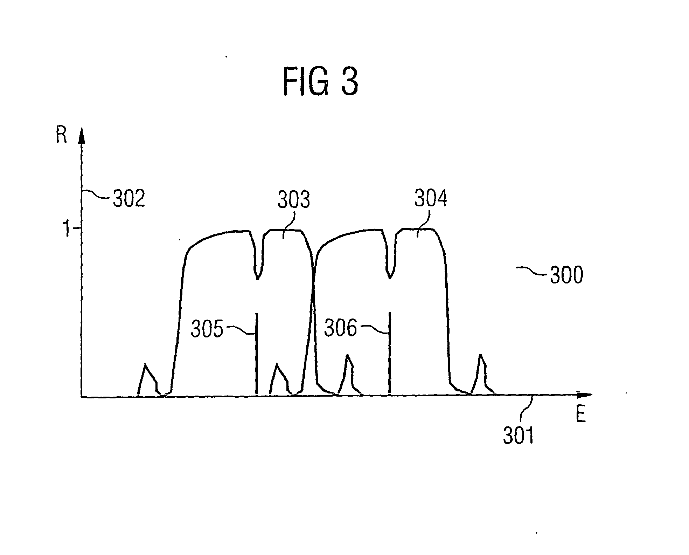

**Fig.3** zeigt das der Erfindung zugrunde liegende Prinzip in einem Resonanzdiagramm 300, welches über einer Energieachse 301 die Reflektivität R 302 des ersten 102 und des zweiten Resonators 103 darstellt.

Gezeigt sind Reflexionskurven 304, 303 des ersten 102 und des zweiten Resonators 103. Der Peak 306 zeigt die Energie der Lasermode des ersten Resonators während der Peak 305 die exzitonischen Grundzustandsenergie eines Quantenpunkts in der Quantenpunkt-Schicht 120 des zweiten Resonators 103 zeigt.

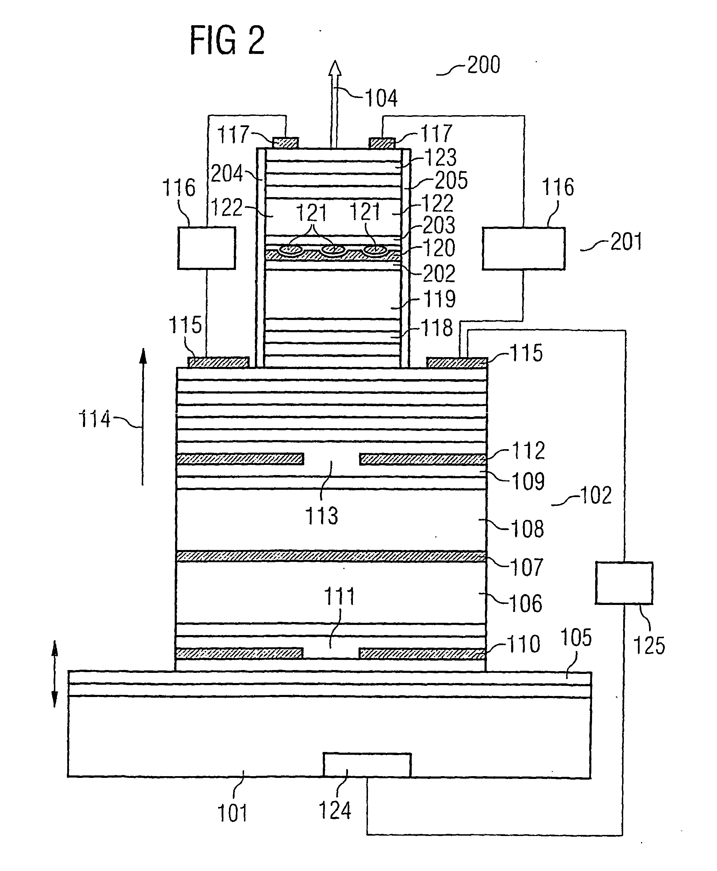

**Fig.2** zeigt einen Photonen-Emitter 200 gemäß einem zweiten Ausführungsbeispiel der Erfindung.

Bei dem Photonen-Emitter 200 gemäß dem zweiten Ausführungsbeispiel der Erfindung sind die mit dem Photonen-Emitter 100 gemäß dem ersten Ausführungsbeispiel der Erfindung identischen Elemente mit identischen Bezugszeichen versehen.

Der erste Resonator 102 entspricht dem ersten Resonator 102 des Photonen-Emitters 100 gemäß dem ersten Ausführungsbeispiel; es unterscheidet sich lediglich der Aufbau des zweiten Resonators 201 des Photonen-Emitters 200 von dem zweiten Resonator 103 des Photonen-Emitters 100 gemäß dem ersten Ausführungsbeispiel.

Im Unterschied zu dem zweiten Resonator 218 gemäß dem ersten Ausführungsbeispiel der Erfindung ist auf der dritten Begrenzungsschicht 119 gemäß diesem Ausführungsbeispiel eine erste Tunnelbarrieren-Schicht 202 der Dicke von 10 bis 20 nm aus Aluminium-Arsenid aufgewachsen, die einen Tunneleffekt von Ladungsträgern aus den Quantenpunkten 121 der Quantenpunkt-Schicht 120 verhindert. Ebenso verhindert den Tunneleffekt eine auf der Quantenpunkt-Schicht 120 aufgebrachte zweite Tunnelbarrieren-Schicht 203, ebenfalls aus Aluminium-Arsenid der Dicke 10 bis 20 nm.

Auf der zweiten Tunnelbarrieren-Schicht 203 ist nunmehr die vierte Begrenzungsschicht 122 aufgewachsen und darauf die vierte Reflektorschicht 123.

Weiterhin ist an den Seitenwänden 204 des zweiten Resonators 201 eine Spiegelschicht 205, allgemein eine Verspiegelung aufgebracht, wodurch der Wirkungsgrad des zweiten Resonators 201 weiter erhöht wird.

Im Weiteren wird beispielhaft eine Abschätzung der benötigten Flächendichte $N_Q$ der Quantenpunkte im Photonen-Emitter angegeben, damit statistisch nur ein Quantenpunkt räumlich und spektral innerhalb der Resonatormode $[-2\sigma_C, 2\sigma_C]$ liegt.

Für die Abschätzung wird jeweils ein Gaußprofil für die spektrale Form der Mode und die spektrale Verteilung der Quantenpunkte mit den Standartabweichungen $\sigma_C$ und $\sigma_E$ angenommen.

Des weiteren werden Designparameter für den Mikroresonator gemäß der Veröffentlichung [4] zugrunde gelegt.

Angenommene Parameter:

1. Durchmesser des zweiten Resonators: $d = 3\ \mu m$
2. Güte des zweiten Resonators: $Q = 5000 \rightarrow$ Linienbreite $\Delta E = 0.26$ meV (bei 1.305 eV)
3. Emissionswellenlänge: $\lambda = 950$ nm $\rightarrow E = 1.305$ eV
4. Effektive Fläche der Grundmode: $A = \pi d^2/16 = 1.77\ \mu m^2$
5. Halbwertsbreite der Quantenpunkt-Photolumineszenz: 50 meV
6. Linienbreite der Quantenpunkte ist schmäler als 0.26 meV (Ist für tiefe Temperaturen im InAs/GaAs System immer erfüllt ($\Delta E < 0.07$ meV)

Mit Hilfe der standardisierten Form der Normalverteilung lässt sich mit obigen Parametern die gesuchte Flächendichte abschätzen.

Ergebnis für obige Parameter:

| $N_Q$ [cm$^{-2}$] | Durchschnittliche Zahl der Quantenpunkte innerhalb der Resonatormode $[-2\sigma_C, 2\sigma_C]$ |
|---|---|
| $10^{11}$ | 14.1 |
| $10^{10}$ | 1.4 |
| $10^9$ | 0.14 |
| $7 \times 10^9$ | 1 |
| | |

Es ergibt sich somit bei einer Flächendichte von $N_Q = 7 \times 10^9$ Quantenpunkten/cm$^2$ statistisch ein Quantenpunkt innerhalb der Resonatormode. Mit Hilfe des Quanten-Confined-Stark Effekts lässt sich dann die genaue Resonanzbedingung (exakter Überlapp) herstellen.

In diesem Dokument sind folgende Veröffentlichungen zitiert:

[1] J. Kim et al., A Single Photon-Turnstile Device, Letters to Nature, Vol. 397, S. 500 - 503, Februar 1999

[2] J.-M. Gerard und B. Gayral, Strong Percell Effect for InAs Quantum Boxes in a Three-Dimensional Solid-State Microcavity, IEEE Journal of Lightwave Technology, Vol. 17, Nr. 11, S. 2089 - 2095, November 1999

[3] P. Michler et al., A Quantum Dot Single-Photon Turnstile-Device, Science, Vol. 290, S. 2282 - 2285, Dezember 2000

[4] J.-M. Gerard et al., Phys. Rev. Lett. 81, 1110, 1998

[5] DE 199 47 853 A1

[6] EP 1 037 341 A2

[7] Patent Abstracts of Japan 10209572 A

[8] J.A. Lott et al, InAs-InGaAs quantum dot VCSELs on GaAs substrates emitting at 1,3 µm, Electronics Letters, Vol. 36, No. 16, S. 1384 - 1385, August 2000

**Bezugszeichenliste**

| 100 | Photonen-Emitter |
| 101 | Substrat |
| 102 | Erster Resonator |
| 103 | Zweiter Resonator |
| 104 | Pfeil |
| 105 | Erste Resonatorschicht |
| 106 | Erste Begrenzungsschicht |
| 107 | Aktive Schicht |
| 108 | Zweite Begrenzungsschicht |
| 109 | Zweite Resonatorschicht |
| 110 | Erste Blende |
| 111 | Erste Öffnung |
| 112 | Zweite Blende |
| 113 | Zweite Öffnung |
| 114 | Pfeil |
| 115 | Erster elektrischer Kontakt |
| 116 | Steuerungseinheit |
| 117 | Zweiter elektrischer Kontakt |
| 118 | Dritte Resonatorschicht |
| 119 | Dritte Begrenzungsschicht |
| 120 | Quantenpunktschicht |
| 121 | Quantenpunkt |
| 122 | Vierte Begrenzungsschicht |
| 123 | Vierte Resonatorschicht |
| 124 | Weiterer elektrischer Kontakt |
| 125 | Weitere Steuerungseinheit |
| 200 | Photonen-Emitter |
| 201 | Zweiter Resonator |
| 202 | Erste Tunnelbarrieren-Schicht |
| 203 | Zweite Tunnelbarrieren-Schicht |
| 204 | Oberfläche zweiter Resonator |
| 205 | Spiegelschicht |

300     Reflexionsdiagramm
301     Energie
302     Reflektivität
303     Reflexionskurve zweiter Resonator
304     Reflexionskurve erster Resonator
305     Energie der Lasermode erster Resonator
306     Exzitonischer Grundzustand Quantenpunkt

**Patentansprüche**

1.  Einzel-Photonen-Emitter

    • mit einem strahlungsemittierenden ersten Resonator (102),
    • mit einem zweiten Resonator (103) mit einer Mehrzahl von Quantenpunkten,
    • wobei der zweite Resonator derart in Emissionsrichtung der von dem ersten Resonator emittierten Strahlung angeordnet ist, dass mindestens ein Quantenpunkt der Mehrzahl von Quantenpunkten (121) in dem zweiten Resonator von der emittierten Strahlung energetisch anregbar ist, und
    • mit einer Steuerungseinheit (116), die mit dem zweiten Resonator gekoppelt ist zum Einstellen des exzitonischen Grundzustands mindestens eines Quantenpunktes der Mehrzahl von Quantenpunkten in dem zweiten Resonator, und die derart eingerichtet ist, dass der exzitonische Grundzustand genau eines Quantenpunktes der Mehrzahl von Quantenpunkten in dem zweiten Resonator in Resonanz mit einer vorgegebenen Resonatormode des zweiten Resonators bringbar ist, wobei die Flächendichte der Quantenpunkte derart gewählt ist, damit statistisch nur ein Quantenpunkt näumlich und spektral innerhalb der Resonatormode liegt.

2.  Einzel-Photonen-Emitter nach Anspruch 1,
    bei dem der erste Resonator ein vertikal emittierendes Laserelement ist.

3.  Einzel-Photonen-Emitter nach Anspruch 1 oder 2,
    bei dem die Steuerungseinheit (116) derart eingerichtet ist, dass der exzitonische Grundzustand des aktiven Quantenpunkts in dem zweiten Resonator (103) mittels Anlegens eines elektrischen Feldes einstellbar ist.

4.  Einzel-Photonen-Emitter nach einem der Ansprüche 1 bis 3,
    bei dem der erste Resonator (102) und/oder der zweite Resonator (103) als DBR-Resonator ausgestaltet ist/sind.

5.  Einzel-Photonen-Emitter nach einem der Ansprüche 1 bis 4,
    bei dem der erste Resonator (102) und/oder der zweite Resonator (103) als Aluminium-Gallium-Arsenid-Resonator ausgestaltet ist/sind.

6.  Einzel-Photonen-Emitter nach einem der Ansprüche 1 bis 5,
    bei dem der erste Resonator folgende Struktur aufweist:

    • eine erste Reflektorschicht (105),
    • eine auf der ersten Reflektorschicht aufgebrachte erste Begrenzungsschicht (106),
    • eine auf der ersten Begrenzungsschicht aufgebrachte aktive Schicht (107),
    • eine auf der aktiven Schicht aufgebrachte zweite Begrenzungsschicht (108), und
    • eine auf der zweiten Begrenzungsschicht aufgebrachte zweite Reflektorschicht (109).

7.  Einzel-Photonen-Emitter nach Anspruch 6,

    • bei dem die erste Reflektorschicht (105), die erste Begrenzungsschicht (106), die zweite Begrenzungsschicht (108) und die zweite Reflektorschicht (109) Aluminium-Gallium-Arsenid enthält, und
    • bei dem die aktive Schicht (107) Gallium-Arsenid enthält.

8.  Einzel-Photonen-Emitter nach einem der Ansprüche 1 bis 7,
    bei dem der zweite Resonator folgende Struktur aufweist:

    • eine dritte Reflektorschicht (118),

- eine auf der dritten Reflektorschicht aufgebrachte dritte Begrenzungsschicht (119),
- eine auf der dritten Begrenzungsschicht aufgebrachte Quantenpunkt-Schicht (120) mit der Mehrzahl von Quantenpunkten (121),
- eine auf der Quantenpunkt-Schicht aufgebrachte vierte Begrenzungsschicht (122), und
- eine auf der vierten Begrenzungsschicht aufgebrachte vierte Reflektorschicht (123).

9. Einzel-Photonen-Emitter nach Anspruch 8,

- bei dem die dritte Reflektorschicht (118), die dritte Begrenzungsschicht (119), die vierte Begrenzungsschicht (122) und die vierte Reflektorschicht (123) Aluminium-Gallium-Arsenid enthält, und
- bei dem die Quantenpunkt-Schicht (120) Indium-Arsenid oder Indium-Gallium-Arsenid enthält.

10. Einzel-Photonen-Emitter nach Anspruch 8 oder 9,
bei dem zwischen der dritten Reflektorschicht (118) und der Quantenpunkt-Schicht (120) und/oder zwischen der Quantenpunkt-Schicht und der vierten Reflektorschicht (123) eine weitere Tunnelbarrieren-Schicht vorgesehen ist/sind.

11. Einzel-Photonen-Emitter nach einem der Ansprüche 1 bis 9, mit mindestens einem an mindestens einer Seitenwand (204) des zweiten Resonators angebrachten optischen Seitenspiegel (205).

12. Datenübertragungsvorrichtung mit einem Einzel-Photonen-Emitter nach einem der Ansprüche 1 bis 11.


**Claims**

1. Photon emitter

- having a radiation-emitting first resonator (102),
- having a second resonator (103) with at least one quantum dot,
- the second resonator being arranged in the direction of emission of the radiation emitted by the first resonator in such a way that the quantum dot in the second resonator can be excited by the energy of the emitted radiation, and
- having a control unit (116) which is coupled to the second resonator in order to set the excitation ground state of the quantum dot in the second resonator, and which is set up in such a way that the excitation ground state of the quantum dot in the second resonator can be brought into resonance with a prescribed resonator mode of the second resonator, wherein the surface density of the quantum dots is adapted such that there is only one quantum dot spatially and spectrally within the resonator mode.

2. Photon emitter according to Claim 1,
in which the first resonator is a vertically emitting laser element.

3. Photon emitter according to Claim 1 or 2,
in which the control unit (116) is set up in such a way that the excitation ground state of the active quantum dot in the second resonator (103) can be set by means of applying an electric field.

4. Photon emitter according to one of Claims 1 to 3,
in which the first resonator (102) and/or the second resonator (103) is/are configured as DBR resonators.

5. Photon emitter according to one of Claims 1 to 4,
in which the first resonator (102) and/or the second resonator (103) is/are configured as aluminium-gallium-arsenide resonators.

6. Photon emitter according to one of Claims 1 to 5,
in which the first resonator has the following structure:

- a first reflector layer (105),
- a first confinement layer (106) applied to the first reflector layer,
- an active layer (107) applied to the first confinement layer,

- a second confinement layer (108) applied to the active layer, and
- a second reflector layer (109) applied to the second confinement layer.

**7.** Photon emitter according to Claim 6,

- in which the first reflector layer (105), the first confinement layer (106), the second confinement layer (108) and the second reflector layer (109) contain aluminium gallium arsenide, and
- in which the active layer (107) contains gallium-arsenide.

**8.** Photon emitter according to one of Claims 1 to 7,
in which the second resonator has the following structure:

- a third reflector layer (118),
- a third confinement layer (119) applied to the third reflector layer,
- a quantum-dot layer (120), applied to the third confinement layer, with the at least one quantum dot (121),
- a fourth confinement layer (122) applied to the quantum-dot layer, and
- a fourth reflector layer (123) applied to the fourth confinement layer.

**9.** Photon emitter according to Claim 8,

- in which the third reflector layer (118), the third confinement layer (119), the fourth confinement layer (122) and the fourth reflector layer (123) contain aluminium gallium arsenide, and
- in which the quantum-dot layer (120) contains indium arsenide or indium gallium arsenide.

**10.** Photon emitter according to Claim 8 or 9,
in which a further tunnel barrier layer is/are provided between the third reflector layer (118) and the quantum-dot layer (120) and/or between the quantum-dot layer and the fourth reflector layer (123).

**11.** Photon emitter according to one of Claims 1 to 9, having at least one optical wing mirror (205) fitted on at least one side wall (204) of the second resonator.

**12.** Data transmission device having a photon emitter according to one of Claims 1 to 11.

**Revendications**

**1.** Emetteur de photons individuels

- comportant un premier résonateur (102) émettant un rayonnement,
- comportant un deuxième résonateur (103), comprenant un grand nombre de points quantiques,
- le deuxième résonateur étant disposé dans la direction de l'émission du rayonnement émis par le premier résonateur de telle sorte qu'au moins un point quantique de la pluralité de points quantiques (121) se trouvant dans le deuxième résonateur puisse subir une excitation énergique par le rayonnement émis, et
- comportant une unité de commande (116), qui est couplée au deuxième résonateur pour ajuster l'état fondamental excitonique d'au moins un point quantique de la pluralité de points quantiques se trouvant dans le deuxième résonateur, et qui est disposée de façon que l'état fondamental excitonique d'exactement un point quantique de la pluralité de points quantiques se trouvant dans le deuxième résonateur puisse être mis en résonance avec un mode résonateur prédéfini du deuxième résonateur, la densité surfacique des points quantiques étant choisie de façon que, d'un point de vue statistique, il n'y ait qu'un point quantique, au niveau spatial et spectral, à l'intérieur du mode résonateur.

**2.** Emetteur de photons individuels selon la revendication 1, dans lequel le premier résonateur est un élément laser à émission verticale.

**3.** Emetteur de photons individuels selon la revendication 1 ou 2, dans lequel l'unité de commande (116) est montée de façon que l'état fondamental excitonique du point quantique actif se trouvant dans le deuxième résonateur (103) puisse être ajusté par application d'un champ électrique.

**4.** Emetteur de photons individuels selon l'une des revendications 1 à 3, dans lequel le premier résonateur (102) et/ou le deuxième résonateur (103) est/sont configurés comme des résonateurs DBR.

**5.** Emetteur de photons individuels selon l'une des revendications 1 à 4, dans lequel le premier résonateur (102) et/ou le deuxième résonateur (103) est/sont configurés comme des résonateurs à l'arséniure d'aluminium et de gallium.

**6.** Emetteur de photons individuels selon l'une des revendications 1 à 5, dans lequel le premier résonateur a la structure suivante :

- comportant une première couche réfléchissante (105),
- comportant une première couche de délimitation (106), appliquée sur la première couche réfléchissante,
- comportant une couche active (107), appliquée sur la première couche de délimitation,
- comportant une deuxième couche de délimitation (108), appliquée sur la couche active, et
- comportant une deuxième couche réfléchissante (109), appliquée sur la deuxième couche de délimitation.

**7.** Emetteur de photons individuels selon la revendication 6,

- dans lequel la première couche réfléchissante (105), la première couche de délimitation (106), la deuxième couche de délimitation (108) et la deuxième couche réfléchissante (109) contiennent de l'arséniure d'aluminium et de gallium, et
- dans lequel la couche active (107) contient de l'arséniure de gallium.

**8.** Emetteur de photons individuels selon l'une des revendications 1 à 7, dans lequel le deuxième résonateur a la structure suivante :

- comportant une troisième couche réfléchissante (118),
- comportant une troisième couche de délimitation (119), appliquée sur la troisième couche réfléchissante,
- comportant une couche de points quantiques (120), appliquée sur la troisième couche de délimitation, comportant la pluralité de points quantiques (121) ;
- comportant une quatrième couche de délimitation (122), appliquée sur la couche de points quantiques, et
- comportant une quatrième couche réfléchissante (123), appliquée sur la quatrième couche de délimitation.

**9.** Emetteur de photons individuels selon la revendication 8,

- dans lequel la troisième couche réfléchissante (118), la troisième couche de délimitation (119), la quatrième couche de délimitation (122) et la quatrième couche réfléchissante (123) contiennent de l'arséniure d'aluminium et de gallium, et
- dans lequel la couche de points quantiques (120) contient de l'arséniure d'indium ou de l'arséniure d'indium et de gallium.

**10.** Emetteur de photons individuels selon la revendication 8 ou 9, dans lequel on a prévu entre la troisième couche réfléchissante (118) et la couche de points quantiques (120) et/ou entre la couche de points quantiques et la quatrième couche réfléchissante (123) une autre couche barrière à effet tunnel.

**11.** Emetteur de photons individuels selon l'une des revendications 1 à 9, comportant au moins un miroir optique latéral (205), rapporté à au moins une paroi latérale (204) du deuxième résonateur.

**12.** Dispositif de transmission de données, comportant un émetteur de photons individuels selon l'une des revendications 1 à 11.

FIG 1

# FIG 2

FIG 3